# EUROPEAN PATENT APPLICATION

(11) **EP 2 592 624 A2**
(43) Date of publication of application: **15.05.2013**
(21) Application number: 12191837.9
(22) Date of filing: 08.11.2012
(51) Int. Cl.: G11C 13/00, G11C 11/56

(54) **Metal doped non-volatile resistive memory elements**

(30) Priority: 11.11.2011 KR 20110117779
(71) Applicant: Samsung Electronics Co., Ltd, Gyeonggi-do 443-742 (KR)
(72) Inventor: Lee, Chang-bum, 449-712 Gyeonggi-do (KR); Kim, Young-bae, 449-712 Gyeonggi-do (KR); Kim, Kyung-min, 449-712 Gyeonggi-do (KR); Kim, Chang-jung, 449-712 Gyeonggi-do (KR); Lee, Dong-soo, 449-712 Gyeonggi-do (KR); Lee, Myoung-jae, 449-712 Gyeonggi-do (KR); Lee, Seung-ryul, 449-712 Gyeonggi-do (KR); Chang, Man, 449-712 Gyeonggi-do (KR)
(74) Representative: Greene, Simon Kenneth

(57) **Abstract**

Non-volatile memory elements, memory devices including the same, and methods for operating and manufacturing the same may include a memory layer between a first electrode and a second electrode spaced apart from the first electrode. The memory layer may include a first material layer and a second material layer, and may have a resistance change characteristic due to movement of ionic species between the first material layer and the second material layer. At least the first material layer of the first and second material layers may be doped with a metal.

## Description

### BACKGROUND

### Field

Example embodiments relate to non-volatile memory elements, memory devices including the same, and methods for operating and manufacturing the same.

### Description of the Related Art

Examples of non-volatile memory devices include resistive random access memory (RRAM), magnetic random access memory (MRAM), ferroelectric random access memory (FRAM), phase-change random access memory (PRAM), or the like. Among them, the RRAM is a resistive memory device which stores data based on a resistance change of a material. In the RRAM, the resistance of a resistance-change material is changed from a high-resistance state to a low-resistance state (also referred to as "ON state") when a voltage applied to the resistance-change material is greater than, or equal to, a set voltage. The resistance of the resistance-change material is switched back to the high-resistance state (also referred to as "OFF state") when a voltage applied to the resistance-change material is greater than, or equal to, a reset voltage.

Generally, a resistive memory device includes a storage node and a switching device. The storage node has a resistance-change material layer. The switching device is electrically connected to the storage node, and controls access of a signal to the storage node.

The demands for high density and for high performance of various non-volatile memory devices, such as the resistive memory devices described above, are continuously increasing.

### SUMMARY

Example embodiments relate to non-volatile memory elements, memory devices including the same, and methods for operating and manufacturing the same.

Provided are non-volatile memory elements using resistance change characteristic. Provided are non-volatile memory elements suitable for increasing the integration degree and improving performance of a memory device. Provided are non-volatile memory elements having multi-bit memory characteristic.

Provided are memory devices including the non-volatile memory elements.

Provided are methods of operating the non-volatile memory elements and the memory devices.

Provided are methods of manufacturing the non-volatile memory elements and the memory devices.

Additional aspects will be set forth in part in the description which follows and, in part, will be apparent from the description, or may be learned by practice of the presented example embodiments.

According to example embodiments, a non-volatile memory element includes a first electrode, a second electrode spaced apart from the first electrode, and a memory layer between the first electrode and the second electrode. The memory layer includes a first material layer and a second material layer. The memory layer has a resistance change characteristic due to movement of at least one of ionic species and ionic vacancies between the first material layer and the second material layer. At least the first material layer of the first and second material layers is doped with a metal.

The non-volatile memory element may have a multi-bit memory characteristic due to the first material layer.

The first material layer may be an oxygen-supplying layer, and the second material layer may be an oxygen-exchanging layer.

The first electrode may include at least one of a non-noble metal and a conductive oxide.

The first material layer may include a first metal oxide.

The first metal oxide may include at least one of Ta oxide, Zr oxide, Y oxide, yttria-stabilized zirconia (YSZ), Ti oxide, Hf oxide, Mn oxide, Mg oxide, and a mixture thereof.

The first metal oxide may include TaOₓ (wherein 0 < x < 2.5), for example.

The second material layer may include a second metal oxide, which is the same group as or a different group than the first metal oxide.

The second material layer may have a higher oxygen concentration than that of the first material layer.

The second metal oxide may include at least one of Ta oxide, Zr oxide, Y oxide, yttria-stabilized zirconia (YSZ), Ti oxide, Hf oxide, Mn oxide, Mg oxide, and a mixture thereof.

The second metal oxide may include Ta₂O₅ for example.

The metal may include tungsten (W), for example.

The first material layer may include W-doped TaO₂, and the second material layer may include Ta₂O₅.

The non-volatile memory element may further include a buffer layer between the first electrode and the memory layer.

The buffer layer may include a material configured for raising a potential barrier between the first electrode and the memory layer.

The buffer layer may include at least one of AlOₓ, SiOₓ, SiNₓ, ZrOₓ, HfOₓ, and a mixture thereof.

The buffer layer includes a material having a greater interatomic bonding energy than that of the memory layer.

According to other example embodiments, a memory device includes the non-volatile memory element described above.

The memory device may further include a switching element electrically connected to the non-volatile memory element.

According to yet other example embodiments, a memory device includes a plurality of first wires arranged in parallel to each other, a plurality of second wires arranged in parallel to each other and crossing the plurality of first wires to form a plurality of cross-points, and a plurality of memory cells. Each of the plurality of memory cells are arranged at one of the plurality of cross-points. Each of the plurality of memory cells includes a memory layer having a first material layer and a second material layer. The memory layer has a resistance change characteristic due to movement of at least one of ionic species and ionic vacancies between the first and second material layers. At least the first material layer of the first and second material layers is doped with a metal.

The memory layer may have a multi-bit memory characteristic due to the first material layer.

The first material layer may be an oxygen-supplying layer, and the second material layer may be an oxygen-exchanging layer.

The first material layer may include a first metal oxide. The second material layer may include a second metal oxide, which is the same group as or a different group than the first metal oxide.

The first metal oxide may include at least one of Ta oxide, Zr oxide, Y oxide, yttria-stabilized zirconia (YSZ), Ti oxide, Hf oxide, Mn oxide, Mg oxide, and a mixture thereof.

The first metal oxide may include TaOₓ (where 0 < x < 2.5), for example.

The second metal oxide may include at least one of Ta oxide, Zr oxide, Y oxide, yttria-stabilized zirconia (YSZ), Ti oxide, Hf oxide, Mn oxide, Mg oxide, and a mixture thereof.

The second metal oxide may include Ta₂O₅ for example.

The metal may include tungsten (W), for example.

The first material layer may include W-doped TaO₂, and the second material layer may include Ta₂O₅.

The memory cell may further include a switching element electrically connected to the memory layer.

The memory cell may further include a buffer layer between the first wire and the memory layer.

The buffer layer includes a material having a greater interatomic bonding energy than that of memory layer

The plurality of memory cells may be a plurality of first memory cells, and the memory device may further include a plurality of third wires arranged on the plurality of second wires and crossing the plurality second wires to form a plurality of second cross-points; and a plurality of second memory cells. Each of the plurality of second memory cells may be arranged at one of the plurality of second cross-points.

Each of the plurality of second memory cells may have a reverse structure of the plurality of first memory cells or the same structure as the plurality of first memory cells.

According to further example embodiments, a method of operating a memory device including a non-volatile memory element, the method includes forming a plurality of ON-states of the non-volatile memory element by controlling a current applied to the non-volatile memory element to adjust the non-volatile memory element to a plurality of current levels, and corresponding the plurality of ON-states to a plurality of first data bits.

The current applied to the non-volatile memory element may be controlled by a switching element electrically connected to the non-volatile memory element.

The method may further include resetting the non-volatile memory element to an OFF-state, and corresponding the OFF-state of the non-volatile memory element to a second data bit.

The plurality of ON-states may include at least a first ON-state, a second ON-state and a three ON-state.

The non-volatile memory element may have a multi-bit memory characteristic.

The non-volatile memory element may include a memory layer, and the memory layer may include a first material layer and a second material layer. The memory layer may have a resistance change characteristic due to movement of at least one ionic species and ionic vacancies between the first and second material layers. At least the first material layer of the first and second material layers may be doped with a metal.

The metal may include tungsten (W), for example.

The first material layer may be an oxygen-supplying layer, and the second material layer may be an oxygen-exchanging layer.

The first material layer may include a first metal oxide, and the second material layer may include a second metal oxide.

According to yet further example embodiments, a method of manufacturing a memory device, the method includes forming a first electrode, forming a memory layer on the first electrode, the memory layer including a first material layer and a second material layer, and forming a second electrode on the memory layer. The memory layer has a resistance change characteristic due to movement of at least one of ionic species or ionic vacancies between the first and second material layers. At least the first material layer of the first and second material layers is doped with a metal.

The forming of the memory layer may include forming a first material layer on the first electrode, forming a metal layer on the first material layer, and diffusing metal atoms of the metal layer into the first material layer.

The diffusing of the metal atoms into the first material layer may include performing a plasma oxidation process.

The second material layer may be formed on the first material layer via the plasma oxidation process.

The non-volatile memory element may have a multi-bit memory characteristic due to the first material layer.

The first material layer may include a first metal oxide, and the second material layer may include a second metal oxide, which is the same group as or a different group than the first metal oxide.

The metal may include tungsten (W), for example.

The method may further include forming a buffer layer between the first electrode and the memory layer.

The forming of the buffer layer may include using a material configured for raising a potential between the first electrode and the memory layer.

The forming of the buffer layer may include using a material having a greater interatomic bonding energy than that of the memory layer.

The method may further include forming a switching element electrically connected to the memory layer.

The forming of the first electrode may include forming the first electrode of at least one selected from non-noble metal and a conductive oxide.

### BRIEF DESCRIPTION OF THE DRAWINGS

These and/or other aspects will become apparent and more readily appreciated from the following description of the embodiments, taken in conjunction with the accompanying drawings in which:
FIG. 1 is a sectional view of a non-volatile memory element according to example embodiments;
FIGS. 2A and 2B are sectional view for describing operating mechanism of a non-volatile memory element according to example embodiments;
FIG. 3 is a sectional diagram of a memory device including the memory element according to example embodiments;
FIG. 4 is a graph showing voltage-current characteristics of a memory device having a structure as shown in FIG. 3;
FIG. 5 is a linear scale graph converted from the graph shown in FIG. 4;
FIGS. 6 and 7 are perspective views of memory devices to which memory elements according to example embodiments are applied;
FIGS. 8A through 8H are sectional views showing a method of manufacturing a memory device, according to example embodiments;
FIGS. 9A through 9G are sectional views showing a method of manufacturing a memory device, according to example embodiments; and
FIG. 10 is a graph showing X-ray photoelectron spectroscopy (XPS) data indicating changes of composition in a depth direction of a memory layer manufactured according to example embodiments.

### DETAILED DESCRIPTION

Various example embodiments will now be described more fully with reference to the accompanying drawings in which example embodiments are shown.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. As used herein the term "and/or" includes any and all combinations of one or more of the associated listed items.

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

Reference will now be made in detail to embodiments, examples of which are illustrated in the accompanying drawings, wherein like reference numerals refer to the like elements throughout. In this regard, the present embodiments may have different forms and should not be construed as being limited to the descriptions set forth herein. Accordingly, the embodiments are merely described below, by referring to the figures, to explain aspects of the present description.

Example embodiments relate to non-volatile memory elements, memory devices including the same, and methods for operating and manufacturing the same.

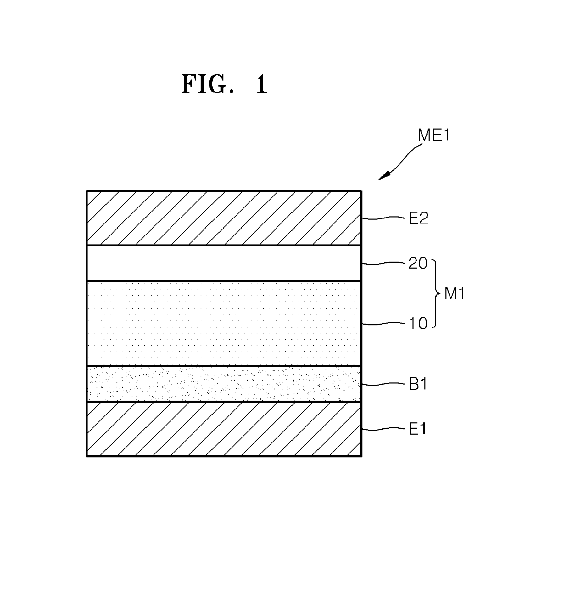

FIG. 1 is a sectional view of a non-volatile memory element (hereinafter, referred to as a memory element) according to example embodiments.

Referring to FIG. 1, a memory element ME1 according to the present example embodiments may include a memory layer M1 interposed between first and second electrodes E1 and E2. The memory layer M1 may have a multi-layer structure. For example, the memory layer M1 may have a double-layer structure consisting of a first material layer 10 and a second material layer 20. The memory layer M1 may have a resistance change characteristic due to movement of ionic species between the first material layer 10 and the second material layer 20. A detailed description thereof is provided below.

The first material layer 10 of the memory layer M1 may be formed of a first metal oxide. For example, the first material layer 10 may contain at least one from among Ta oxide, Zr oxide, Y oxide, yttria-stabilized zirconia (YSZ), Ti oxide, Hf oxide, Mn oxide, Mg oxide, and a mixture thereof. In a case where the first metal oxide contains Ta oxide, the first metal oxide may be TaOₓ (wherein one of the following expressions are true: 0 < x < 2.5 or 0.5≤x≤2.0). Oxygen ions and/or oxygen vacancies may exist in the first material layer 10. The first material layer 10 may function as an oxygen-supplying layer with respect to the second material layer 20. The first material layer 10 may also be referred to as an oxygen reservoir layer. The first material layer 10 may be a layer doped with a desired metal. Here, the desired metal is a metal different from the base material (metal) constituting the first material layer 10. The desired metal may be tungsten (W), for example. By using the first material layer 10 doped with a metal, the memory layer M1 may have a multi-bit memory characteristic. In other words, the memory layer M1 may have a multi-bit memory characteristic due to the first material layer 10 doped with a metal. A detailed description thereof will be provided later in detail. The thickness of the first material layer 10 may be from about 1 nm to about 100 nm, for example, from about 5 nm to about 50 nm.

The second material layer 20 may exchange oxygen ions and/or oxygen vacancies with the first material layer 10, and induce a resistance change of the memory layer M1. In this regard, the second material layer 20 may be referred to as an oxygen-exchanging layer. The second material layer 20 may be formed of a second metal oxide, which may be the same group as or a different group from the first metal oxide. For example, the second metal oxide may contain at least one of Ta oxide, Zr oxide, Y oxide, YSZ, Ti oxide, Hf oxide, Mn oxide, Mg oxide, and a mixture thereof. The second metal oxide may have a stoichiometric composition, or a similar composition thereto. For example, when the second metal oxide includes a Ta oxide, the Ta oxide may be a Ta₂O₅ layer or a layer having a composition similar to Ta₂O₅. Similar to the first material layer 10, the second material layer 20 may contain oxygen ions and/or oxygen vacancies. Oxygen mobility (or oxygen diffusivity) of the second material layer 20 may be equal to, or greater than, that of the first material layer 10. Resistivity of the second material layer 20 may differ from that of the first material layer 10. For example, the resistivity of the second material layer 20 may be greater than that of the first material layer 10. In the "ON state" in which a current path is formed in the second material layer 20, the electric resistance of the memory layer M1 may be determined by the electric resistance of the first material layer 10. In the "OFF state" in which no current path exists in the second material layer 20, the electric resistance of the memory layer M1 may be determined by the electric resistance of the second material layer 20. Oxygen concentration of the second material layer 20 may be higher than that of the first material layer 10. However, in certain cases, the oxygen concentration of the second material layer 20 may not be higher than that of the first material layer 10. In a case where the second material layer 20 is formed of the same metal oxide as the first material layer 10, the oxygen concentration of the second material layer 20 may be higher than that of the first material layer 10. However, in a case where the second material layer 20 is formed of a metal oxide different from that of the first material layer 10, the oxygen concentration of the second material layer 20 is not necessarily higher than that of the first material layer 10. The thickness of the second material layer 20 may be smaller than that of the first material layer 10. The thickness of the second material layer 20 may be from about 1 nm to about 50 nm, for example, from about 5 nm to about 20 nm. According to material properties of the second material layer 20 (i.e., the oxygen-exchanging layer), the resistance change characteristics of the memory element ME1 (e.g., switching speed, ON/OFF ratio, etc.) may vary.

Furthermore, similar to the first material layer 10, at least a portion of the second material layer 20 may be doped with a desired metal. The desired metal may be same as the metal with which the first material layer 10 is doped. For example, the second material layer 20 may be doped with tungsten (W). However, it is optional to dope the second material layer 20 with a metal. Therefore, at least the first material layer 10 may be doped with a metal, and, if desired, the second material layer 20 may also be doped with a metal.

A buffer layer B1 may be interposed between the memory layer M1 and the first electrode E1 (more specifically, between the first material layer 10 and the first electrode E1). The buffer layer B1 may improve reliability, reproducibility, and stability of resistance change characteristics of the memory layer M1. The buffer layer B1 may contain (or, include) a material with a greater interatomic bonding energy than the memory layer M1. In other words, the interatomic bonding energy of the buffer layer B1 may be greater than the interatomic (e.g., Ta-O) bonding energy of the first material layer 10. In other words, the buffer layer B1 may be formed of a material that is more stable than the memory layer M1 in terms of bonding energy. Furthermore, the buffer layer B1 may contain a material that raises the potential barrier between the first electrode E1 and the memory layer M1. In other words, a conduction band offset between the buffer layer B1 and the first electrode E1 may be greater than that between the first material layer 10 and the first electrode E1. In other words, the buffer layer B1 may be formed of a material that suppresses an excessive current flow between the first electrode E1 and the first material layer 10. In order to get a similar effect, the buffer layer B1 may contain (or, include) a material with a higher resistivity than the memory layer M1. For example, the buffer layer B1 may contain (or, include) at least one of AlOₓ, SiOₓ, SiNₓ, ZrOₓ, HfOₓ, and a mixture thereof. The buffer layer B1 may, or may not, have a stoichiometric composition. The buffer layer B1 may have a suitable composition and thickness to function as a buffer and to allow the flow of the electric current. The thickness of the buffer layer B1 may be less than, or equal to, about 10 nm, for example. If the buffer layer B1 has a stoichiometric composition, the thickness of the buffer layer B1 may be less than, or equal to, about 5 nm. If the buffer layer B1 has an excessive thickness, insulation properties of the buffer layer B1 may undesirably increase. Therefore, as described above, the buffer layer B1 may be formed to have a thickness less than, or equal to, about 10 nm.

The first electrode E1 may be formed of a base metal (e.g., tungsten (W), nickel (Ni), aluminum (Al), titanium (Ti), tantalum (Ta), titanium nitride (TiN), titanium tungsten (TiW), tantalum nitride (TaN), etc.), or a conductive oxide (e.g., indium zinc oxide (IZO), indium tin oxide (ITO), etc). Because the buffer layer B1 is provided in the present example embodiments, stable memory properties may be acquired without forming the first electrode E1 of an expensive noble metal. In a case where the first electrode E1 is formed of an expensive noble metal with low reactivity, the buffer layer B1 may not be necessary, but manufacturing costs increase. Furthermore, even if the first electrode E1 is formed of a noble metal, it may be difficult to secure reproducibility and/or stability of the resistance change characteristics. According to the present example embodiments, because the buffer layer B1 is used, reproducibility and/or stability of resistance change characteristics may be easily acquired even if the first electrode E1 is formed of an inexpensive material. However, the present example embodiments are not limited thereto. If desired, the first electrode E1 may be formed of noble metals (e.g., iridium (Ir), ruthenium (Ru), palladium (Pd), gold (Au), platinum (Pt), etc.), or metal oxides (e.g., iridium oxide IrO₂). Therefore, the first electrode E1 may contain at least one selected from a group consisting of W, Ni, Al, Ti, Ta, TiN, TiW, TaN, IZO, ITO, Ir, Ru, Pd, Au, Pt, IrO₂ and alloys thereof. Furthermore, although not stated herein, the first electrode E1 may be formed of any of various electrode materials commonly used in semiconductor devices.

Similar to the first electrode E1, the second electrode E2 may be formed of any of various materials. For example, the second electrode E2 may be formed of a noble metal (e.g., Ir, Ru, Pd, Au, and Pt), a metal oxide (e.g., IrO₂), a non-noble metal (i.e., base metal) (e.g., W, Ni, Al, Ti, Ta, TiN, TiW, and TaN), or a conductive oxide (e.g., IZO and ITO). However, materials constituting the second electrode E2 are not limited to the above-stated materials.

Although not shown, a second buffer layer having a similar function as the buffer layer B1 may be interposed between the second electrode E2 and the memory layer M1. In other words, the second buffer layer may be interposed between the second electrode E2 and the second material layer 20. Materials and functions of the second buffer layer may be similar to those of the buffer layer B1. If the second buffer layer is used, reliability, reproducibility, and stability of resistance change characteristics of the memory layer M1 may be further improved, and a number of materials that may be used for forming the second electrode E2 may increase.

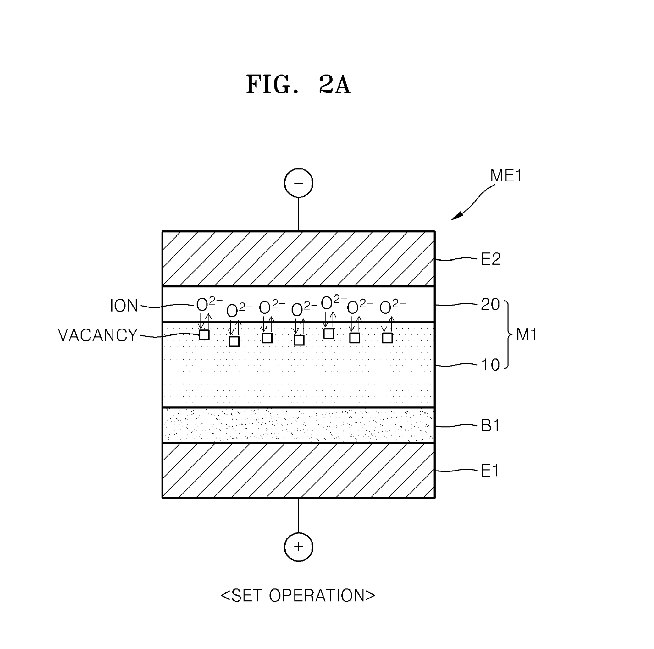

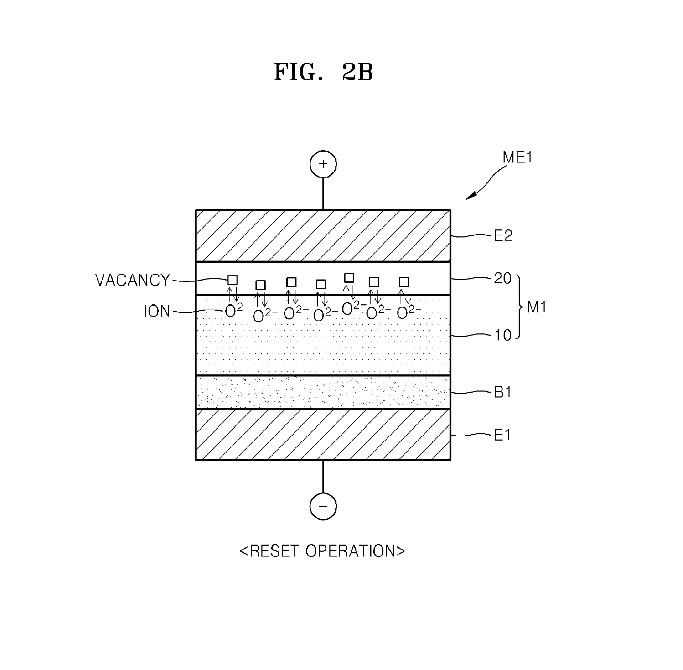

Hereinafter, referring to FIGS. 2A and 2B, the resistance changing mechanism of the memory element ME1 is described in detail.

As shown in FIG. 2A, during a set operation in which a positive (+) voltage is applied to the first electrode E1, and a negative (-) voltage is applied to the second electrode E2, oxygen vacancies move from the first material layer 10 to second material layer 20. Thus, a current path (not shown) may be formed in the second material layer 20. As a result, the electric resistance of the memory layer M1 may decrease. In other words, the memory layer M1 may be switched from an "OFF state" to an "ON state." During the set operation, oxygen ions may move in a direction opposite to the direction in which the oxygen vacancies move (i.e., oxygen ions may move from the second material layer 20 to the first material layer 10).

As shown in FIG. 2B, during a reset operation in which a negative (-) voltage is applied to the first electrode E1 and a positive (+) voltage is applied to the second electrode E2, oxygen vacancies move from the second material layer 20 to the first material layer 10 (e.g., oxygen ions move from the first material layer 10 to the second material layer 20). Thus, the current path formed in the second material layer 20 may be broken. As a result, the electric resistance of the memory layer M1 may increase. In other words, the memory layer M1 may be switched from an "ON state" to an "OFF state."

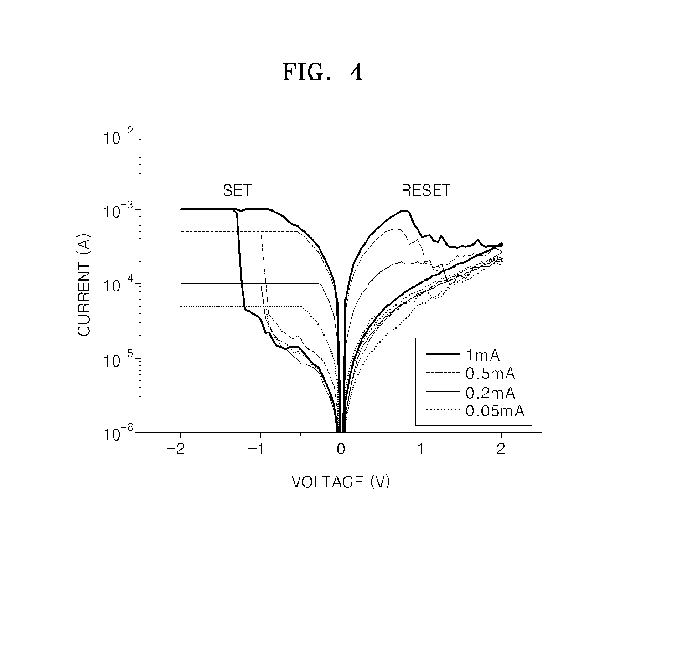

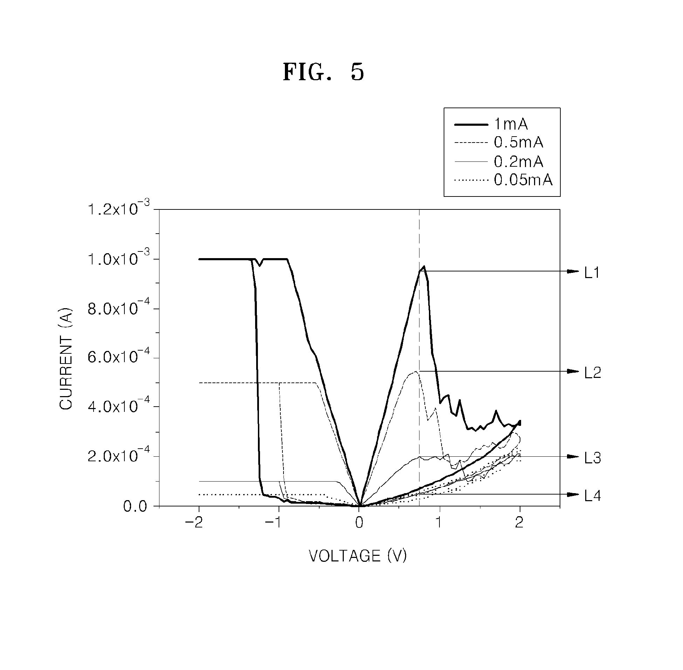

As described above, the first metal layer 10 doped with a metal may provide a multi-bit memory characteristic to the memory layer M1. In a case where the first metal layer 10 is not doped with a metal, the memory element ME1 may exhibit a single-bit memory characteristic. However, if the first metal layer 10 doped with a metal is used, the memory element ME1 may exhibit a multi-bit memory characteristic. In other words, the resistance state of the memory layer M1 may be divided into a plurality of states by the first material layer 10 doped with a metal (e.g., four states or more). Effects of the first material layer 10 will be described in more detail with reference to FIGS. 4 and 5.

The buffer layer B1 may improve stability, reliability, and reproducibility of resistance change characteristics of the memory element ME1 during the set/reset operations. In a case where the buffer layer B1 is not provided, oxygen ions and/or oxygen vacancies affecting resistance changes during the set/reset operations may move toward the first electrode E1 and physically and/or chemically react with the first electrode E1, or the memory layer M1 itself may physically/chemically react with the first electrode E1. As a result, there may be problems in stability, reliability, and reproducibility of the resistance change characteristics. For example, a current between the first electrode E1 and the memory layer M1 may rapidly and undesirably increase. Furthermore, due to a reaction between the memory layer M1 and the first electrode E1, an undesired material layer may be formed therebetween. Thus, the characteristics of resistance change may deteriorate. The problems may become more serious in a case where the first electrode E1 is formed of an inexpensive non-noble metal. Furthermore, repetitive switching operations between the "ON" and "OFF" states may increase the possibility of having those problems mentioned previously. When a TaOₓ layer is used as a resistance changing material, the characteristics of resistance change may significantly vary based on a method of formation, depositing conditions, and oxygen content of the TaOₓ layer. Thus, it is very difficult to secure reproducibility and stability of the characteristics of resistance change. According to example embodiments, the problems stated previously, however, may be suppressed (or, alternatively, prevented) while improving and securing the reliability, reproducibility, and stability of characteristics of resistance change by forming the buffer layer B1 between the first electrode E1 and the memory layer M1. Particularly, during the initial set operation (i.e., during the forming operation), the buffer layer B1 may reduce (or, alternatively, prevent) chemical reactions between the first electrode E1 and the first material layer 10, and between the first electrode E1 and ionic species of the first material layer 10. Furthermore, the buffer layer B1 may prevent the first material layer 10 and the first electrode E1 from reacting with each other during formation of the first material layer 10. By introducing the buffer layer B1, the first electrode E1 may not only be formed of a noble metal, but also be formed of an inexpensive non-noble metal or a conductive oxide. Without the buffer layer B1, it may be practically difficult to form the first electrode E1 of a non-noble metal with high reactivity or a conductive oxide. The use of a noble metal for the first electrode E1 may increase the cost of fabrication and place some limits in fabricating processes of a memory element. When the first electrode E1 is formed of a non-noble metal or a conductive oxide instead of a noble metal, the costs of fabrication may decrease and there may be further merits in fabricating processes.

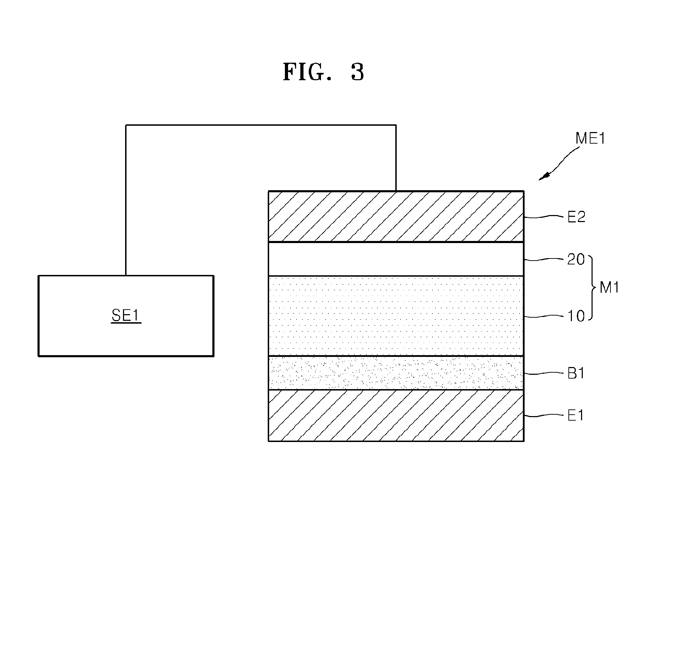

FIG. 3 is a sectional diagram of a memory device including the memory element ME1 shown in FIG. 1, according to example embodiments.

Referring to FIG. 3, the memory device according to example embodiments may include the memory element ME1 and a switching element SE1 (electrically) connected thereto. The switching element SE1 may be connected to an end of the memory element ME1 (e.g., second electrode E2). However, if desired, the switching element SE1 may be connected to another end of the memory element ME1 (e.g., first electrode E1), or may be connected to two ends of the memory element ME1 (i.e., the first and second electrodes E1 and E2). The switching element SE1 may control a current to be applied to the memory element ME1. In other words, the intensity of current applied to the memory element ME1 may be changed by controlling ON-current of the switching element SE1. By controlling the intensity of current applied to the memory element ME1, a multi-bit memory characteristic of the memory element ME1 may be obtained. A detailed description thereof will be given below with reference to FIGS. 4 and 5. The switching element SE1 may be formed of a transistor, a diode, a threshold switching device, or a varistor, for example. Here, the diode may be a bi-directional (two-way) diode, a Zener diode, etc. However, the configuration of the switching element SE1 is not limited thereto and may vary.

FIG. 4 is a graph showing voltage-current characteristics of a memory device having a structure as shown in FIG. 3. The memory device used to obtain the result shown in FIG. 4 includes a memory element having a structure of W/Al₂O₃/TaOₓ(W-doped)/Ta₂O₅/Pt. In other words, the memory element has the same stacked structure as the memory element ME1 shown in FIG. 3, where the first electrode E1, the buffer layer B1, the first material layer 10, the second material layer 20, and the second electrode E2 are formed of W, Al₂O₃, W-doped TaOₓ, Ta₂O₅ and Pt, respectively. Here, the second material layer 20 (i.e., the Ta₂O₅ layer) may be a layer doped with tungsten (W), like the first material layer 10 (i.e., the W-doped TaOₓ layer). The memory device further includes a switching device connected to the memory element. As the operating current (i.e., ON-current) of the switching element is changed in the order of 1 mA, 0.5 mA, 0.2 mA, and 0.05 mA during a set operation of the memory element, the voltage-current characteristics are measured. During the set operation, the amount of current flowing in the memory element varies according to the operating current of the switching element. The operating current of the switching element may function similarly as a compliance current.

As shown in FIG. 4, the ON-current level of the memory element is divided into a plurality of levels according to a level of the operating current of the switching element. In other words, the memory element may be set at various (or, different) current levels according to the operating current of the switching element. The plurality of ON-current levels of the memory element may correspond to a plurality of bits of data, respectively. Therefore, the memory element according to example embodiments may exhibit a multi-bit memory characteristic.

FIG. 5 is a linear scale graph converted from the graph shown in FIG. 4.

Referring to FIG. 5, a first level L1 is the ON-current level of the memory element when the operating current of the switching element is 1 mA. A second level L2 is the ON-current level of the memory element when the operating current of the switching element is 0.5 mA. A third level L3 is the ON-current level of the memory element when the operating current of the switching element is 0.2 mA. A fourth level L4 is the OFF-current level of the memory element. The first through third levels L1 through L3 may correspond to a plurality of ON-states of the memory element, whereas the fourth level L4 may correspond to an OFF-state of the memory element. Each of the first through fourth levels L1 through L4 shows a clear difference from the others. The first level L1 may correspond to data "00," the second level L2 may correspond to data "01," the third level L3 may correspond to data "10," and the fourth level L4 may correspond to data "11." Therefore, the memory element according to example embodiments may have a multi-bit memory characteristic. Here, the first through fourth levels L1 through L4 are detected at a desired positive (+) voltage.

Although a case in which the three ON-current levels L1 through L3 and the one OFF-current level L4 respectively correspond to the four bits of data 00, 01, 10, and 11 is described with respect to FIG. 5, it is merely an example. If desired, four ON-current levels may correspond to the four bits of data 00, 01, 10, and 11. For example, in FIG. 5, the fourth level L4 (OFF-current level) is very similar to ON-current level of the memory element when the operating current of the switching element is 0.05 mA, the ON-current level may correspond to a desired data (e.g., the data "11"), instead of the fourth level L4 (i.e., OFF-current level). Furthermore, if it is possible to acquire seven or more ON-current levels that may be distinguished from each other, the seven ON-current levels and one OFF-current level may correspond to a plurality of bits of data 000, 001, 010, 100, 011, 101, 110, and 111. Thus, 3-bit memory characteristic may be embodied (or realized).

Furthermore, FIGS. 4 and 5 show a case in which the ON-current level of a memory element is divided into a plurality of levels by controlling the operating current (i.e., ON-current) of a switching element during a set operation of the memory element. However, according to other example embodiments, a plurality of compliance currents may be used instead of controlling the operating current of the switching element. In other words, during a set operation of the memory element, the ON-current level of the memory element may be divided into a plurality of levels by controlling the intensity of the compliance current applied to the memory element.

A method of operating a memory device including a memory element according to example embodiments will be briefly described below now with reference to FIGS. 4 and 5.

The method of operating a memory device may include a first step for forming a plurality of ON-states of a non-volatile memory element (hereinafter, referred to as a memory element) by changing a current applied to the memory element, and a second step for corresponding the plurality of ON-states to a plurality of bits of data. The first step may correspond to the operation for setting the memory element at various current levels by controlling a current applied to the memory element, as described above with reference to FIG. 4. In this manner, the ON-state of the memory element may be divided into a plurality of ON-states. The second step may correspond to the operation for corresponding a plurality of ON-states to a plurality of bits of data, as described above with reference to FIG. 5.

A current applied to the memory element in the first step may be controlled by a switching element connected to the memory element. The switching element may be the switching element SE1 shown in FIG. 3. However, if desired, the current applied to the memory element may be controlled by using other means than the switching element.

The method of operating the memory device may further include a step for resetting the memory element to an OFF-state, and a step for corresponding the OFF-state to a bit of data. The OFF-state may correspond to the fourth level L4 shown in FIG. 5, for example. However, it is optional to use data corresponding to the OFF-state.

The memory element may have three or more ON-states. Three ON-states and one OFF-state may correspond to a plurality of bits of data, respectively. As a result, multi-bit memory characteristics may be embodied (or, realized). If desired, four or more ON-states may correspond to a plurality of bits of data.

The method of operating a memory device according to example embodiments may be one regarding a memory device having a structure as shown in FIG. 3. In other words, the memory element may have a structure that is the same (or similar) as that of the memory element ME1 shown in FIG. 3. Therefore, the memory element may include a memory layer, and the memory layer may include first and second material layers. The memory layer may have a resistance change characteristic due to movement of ionic species between the first and second material layers. The first material layer may be an oxygen-supplying layer, whereas the second material layer may be an oxygen-exchanging layer. The first material layer may be formed of a first metal oxide, and the second material layer may be formed of a second metal oxide. At least the first material layer of the first and second material layers may be doped with a metal. The metal may be tungsten (W), for example. A switching element (electrically) connected to the memory element may be the same as, or similar to, the switching element SE1 shown in FIG. 3. However, the method of operating a memory device according to example embodiments may be applied not only to a memory device having the structure of FIG. 3, but also to a memory element having any of various other structures.

In conventional methods for operating memory devices, it is common to divide the OFF-state of a memory element into a plurality of OFF-states and to respectively correspond the plurality of OFF-states to a plurality of bits of data. However, according to example embodiments, the ON-state of a memory element is divided into a plurality of ON-states, and the plurality of ON-states correspond to a plurality of bits of data, respectively. Because a memory device having a structure as shown in FIG. 3 is used in present example embodiments, a plurality of ON-states that may be clearly distinguished from each other may be easily formed.

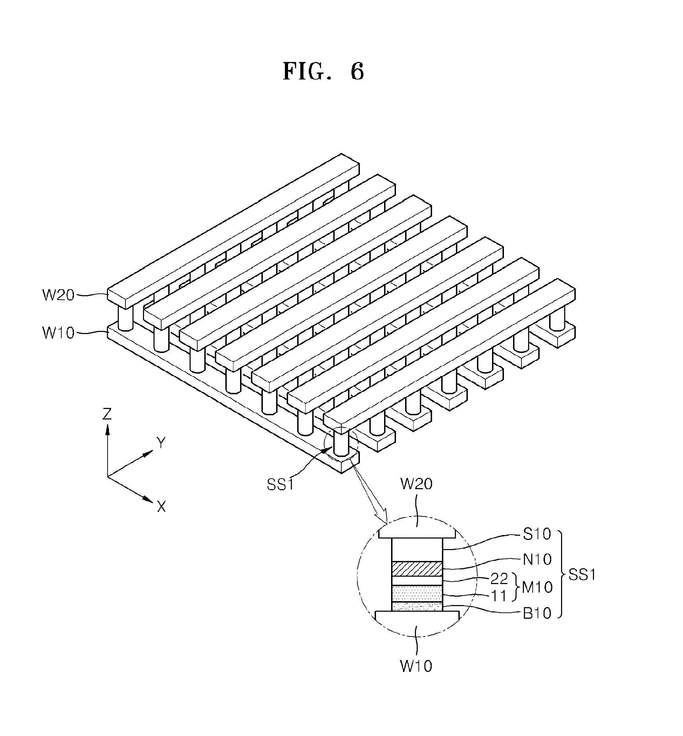

FIG. 6 is a perspective view of a memory device which includes a memory element according to example embodiments. The memory device illustrated in FIG. 6 is a cross-point resistive memory device.

Referring to FIG. 6, a plurality of first wires W10 are formed in parallel to each other in a first direction (e.g., the x-axis direction) may be arranged. A plurality of second wires W20 that are formed in a direction crossing the first wires W10 (e.g., the y-axis direction) may be arranged. A first stacked structure (i.e., first memory cell) SS1 may be arranged at each point where the first wires W10 and the second wires W20 cross each other. The first stacked structure SS1 may include a first buffer layer B10, a first memory layer M10, a first intermediate electrode N10, and a first switching element S10 that are stacked on the first wires W1 in the order stated. The first memory layer M10 may include a first material layer 11 and a second material layer 22. Between the first material layer 11 and the second material layer 22, at least the first material layer 11 may be doped with a metal. The first and second material layers 11 and 22 may be doped with a metal. The metal may be tungsten (W), for example. In the first stacked structure SS1, locations of the lower structure including the first buffer layer B10 and the first memory layer M10, and the upper structure including the first switching element S10, may be switched with respect to the first intermediate electrode N10. The first buffer layer B10 and the first memory layer M10 may respectively correspond to the buffer layer B1 and the memory layer M1 of FIG. 1. The first switching element S10 may be formed of a bi-directional (two-way) diode, a Zener diode, a threshold switching device, a varistor, or the like. In a case where the first switching element S10 is a bi-directional diode, the bi-directional diode may be an oxide diode. In a case of a silicon diode, it is necessary to form the silicon diode at a relatively high temperature around 800°C, and thus there are limits to selectable substrates. Furthermore, various problems may occur due to the high temperature. Therefore, favorable characteristics may be acquired by forming the first switching element S10 by using an oxide layer that is easily formed at room temperature. However, example embodiments are not limited thereto. If desired, the first switching element S10 may be formed of silicon or any of various other materials. The first wires W10 and the first intermediate electrode N10 may correspond to the first electrode E1 and the second electrode E2 of FIG. 1, respectively. The second wires W20 may, or may not, be formed of the same material as the first wires W10. Furthermore, the first buffer layer B10 may be omitted.

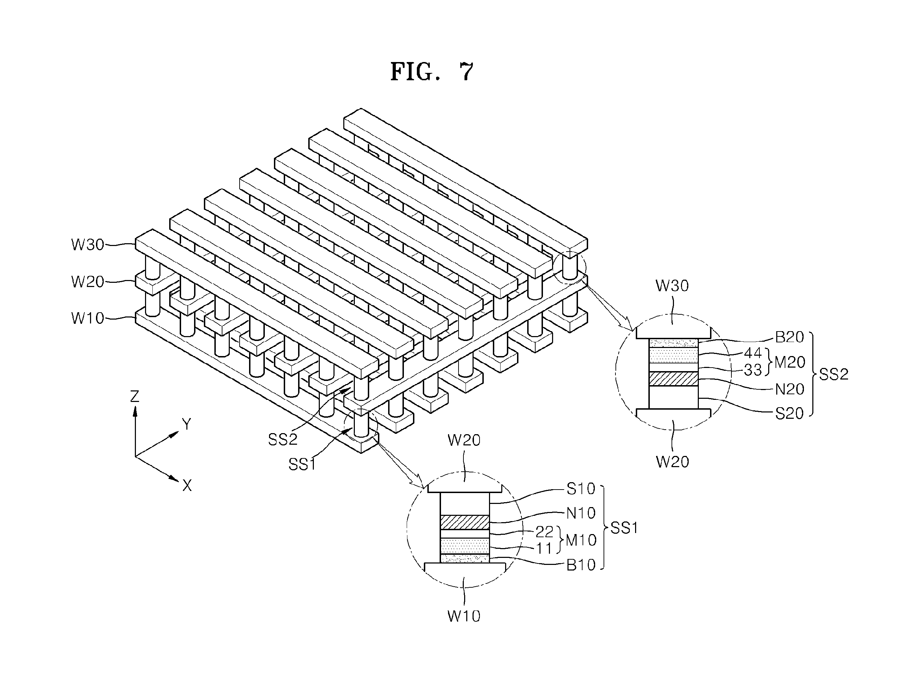

A second memory cell and a plurality of third wires (W30 in Fig. 7) may be further arranged on the second wires W20 of FIG. 6. An example thereof is shown in FIG. 7.

Referring to FIG. 7, the first wires W10, the second wires W20, and the first stack structures SS1 (i.e., first memory cells) arranged therebetween may be formed. Furthermore, the plurality of third wires W3 may be further disposed at a desired space from top surfaces of the second wires W2. The third wires W30 may cross the second wires W20 and may be arranged apart from each other by the same interval. A second stacked structure SS2 (i.e., a second memory cell) may be arranged at each point where the second wire W20 and the third wire W30 cross each other. The second stacked structure SS2 may have a reverse structure of the first stacked structure SS1, or the same structure as the first stacked structure SS1. Here, a case where the second stacked structure SS2 has the reverse structure of the first stacked structure SS1 is shown. In detail, the second stacked structure SS2 may include a second switching element S20, a second intermediate electrode N20, a second memory layer M20, and a second buffer layer B20 that are stacked on the second wire W20 in the order stated. The second memory layer M20 may include a third material layer 33 and a fourth material layer 44. The third material layer 33 and the fourth material layer 44 may be the same material layers as the second material layer 22 and the first material layer 11 of the first stack structure SS1, respectively. The second switching element S20 may have a reverse structure of the first switching element S10, or may have the same stacked structure as the first switching element S10. In other words, the switching direction of the second switching element S20 may be opposite from, or the same as, that of the first switching element S10. The second buffer layer B20 may be the same material layer as the first buffer layer B10. If desired, the second buffer layer B20 may be omitted. In the second stacked structure SS2, locations of the lower structure including the second switching element S20, and the upper structure including the second memory layer M20 and the second buffer layer B20, may be switched with respect to the second intermediate electrode N20. The third wire W30 and the second intermediate electrode N20 may correspond to the first electrode E1 and the second electrode E2 of FIG. 1, or to the second electrode E2 and the first electrode E1, respectively.

Although the first and second stacked structures SS1 and SS2 are shown as cylindrical shapes in FIGS. 6 and 7, the first and second stacked structures SS1 and SS2 may have other various shapes. For example, the first and second stacked structures SS1 and SS2 may have a square pillar shape, or a pillar shape in which the width increases downward (or in a vertical direction). The first and second stacked structures SS1 and SS2 may have asymmetrical shapes. For example, the first and/or second stacked structures may have a section of which a cross sectional area is larger than an area of the cross-points formed by the crossing wires (e.g. the first and second wires W1 and W2, or the second and third wires W2 and W3). It is also possible that the first and/or second stacked structures may have a portion of which a center is off from a center of a cross-point formed by the crossing wires. The shape of the memory device shown in FIGS. 6 and 7 may further be modified within the spirit and scope of example embodiments.

Although not shown, the resistive memory device shown in FIG. 7 may further include a stacked structure that is the same as the stacked structure including the first stacked structures SS1 and the second wires W20 on the third wires W30.

Alternatively, a resistive memory device according to example embodiments may include at least one set of a stacked structure that is the same as the stacked structure including the first stacked structures SS1, the second wires W20, the second stacked structures SS2, and the third wires W30 on the third wires W30.

Alternatively, a resistive memory device according to example embodiments may include at least one set of a stacked structure that is the same as the stacked structure including the first stacked structures SS1, the second wires W20, the second stacked structures SS2, the third wires W30, the first stacked structures SS1, and the second wires W20, which are sequentially stacked, on the third wires W30.

In the memory device shown in FIGS. 6 and 7, the first memory layer M10 may have a multi-bit memory characteristic due to the first material layer 11 doped with a metal, and the second memory layer M20 may have a multi-bit memory characteristic due to the fourth material layer 44 doped with a metal. The reason therefor is as described above with reference to FIGS. 1 through 5, and thus, a detailed description thereof is omitted.

Accordingly, a memory device according to example embodiments has a multi-bit memory characteristic, and thus, it may be easy to increase the amount of information stored per unit area. In other words, a memory device according to example embodiments may be suitable for embodying (or, realizing) a more highly integrated memory device. In a case of a scale-down method performed by reducing line width of a memory device, there are various difficulties in improving the integration degree of the memory device due to process limits. However, as in example embodiments, if multi-bit data is stored in a single memory cell, the amount of information stored per unit area may be twice or more than a single-bit memory. Therefore, example embodiments may be suitable for increasing the integration degree of a memory device.

Hereinafter, methods of manufacturing a memory element, according to example embodiments, and a memory device including the memory element are described.

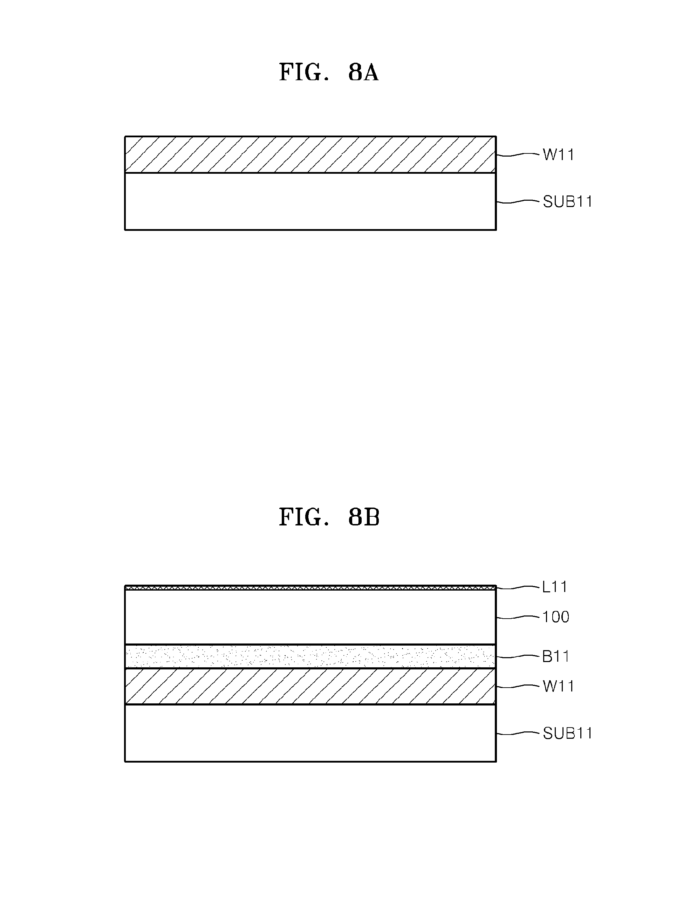

FIGS. 8A through 8H are sectional views showing a method of manufacturing a memory device, according to example embodiments.

Referring to FIG. 8A, a first wire W11 may be formed on a substrate SUB11. The first wire W11 may have a linear shape. Although not shown, an insulation layer having the same height as the first wire W11 may further be formed on the substrate SUB11 around the first wire W11. The first wire W11 may correspond to the first electrode E1 of FIG. 1 or the first wire W10 of FIG. 7. The shape of the first wire W11 is not limited to a linear shape and may vary.

Referring to FIG. 8B, a buffer layer B11, a first material layer 100, and a metal layer L11 may be formed on the first wire W11 in the order stated. A material constituting the buffer layer B11 may correspond to a material constituting the buffer layer B1 of FIG. 1 or the buffer layer B10 of FIG. 7. The first material layer 100 may be formed of a first metal oxide. In detail, the first material layer 100 may be formed to contain at least one from among Ta oxide, Zr oxide, Y oxide, YSZ, Ti oxide, Hf oxide, Mn oxide, Mg oxide, and a mixture thereof, for example. If the first metal oxide is Ta oxide, the first metal oxide may be TaOₓ (where 0 < x < 2.5 or 0.5≤x≤2.0). The metal layer L11 may be formed of tungsten (W), for example. In other words, the metal layer L11 may be a tungsten (W) layer. The thickness of the metal layer L11 may be about several nm. For example, the thickness of the metal layer L11 may be about 2 nm.

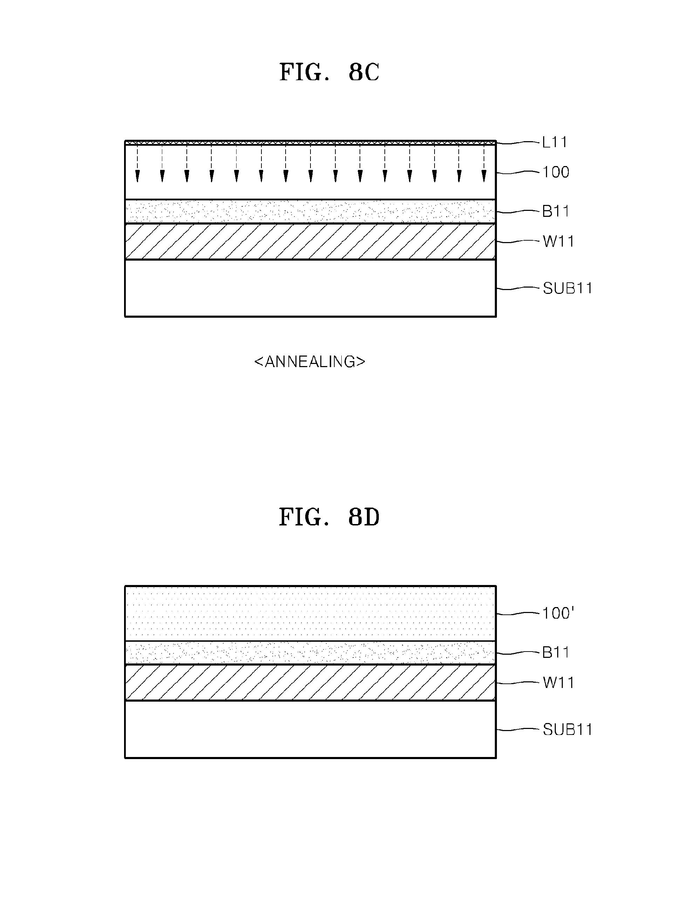

Referring to FIG. 8C, the stacked structure (W11+B11+100+L11) formed on the substrate SUB11 may be annealed. The annealing may be performed at several hundred degrees Celsius (°C). For example, the annealing may be performed at a temperature from about 300°C to about 800°C. As a result, metal atoms (e.g., W atoms) of the metal layer L11 may diffuse into the first material layer 100. The annealing may be performed as a part of a plasma oxidation process. The plasma oxidation process may be performed at a temperature of hundreds of degrees Celsius in an oxygen atmosphere, where the annealing may be performed under the temperature condition. Detailed description thereof is provided below.

As a result, as shown in FIG. 8D, a first material layer 100' doped with metal atoms (e.g., W atoms) may be obtained. The first material layer 100' may correspond to the first material layer 10 of FIG. 1, or the first material layer 11 of FIG. 7. Because the thickness of the metal layer L11 that is formed in the operation shown in FIG. 8B is small, most atoms of the metal layer L11 may be diffused by the annealing. Thus, no metal layer L11 may remain on the first material layer 100', as shown in FIG. 8D, after the annealing.

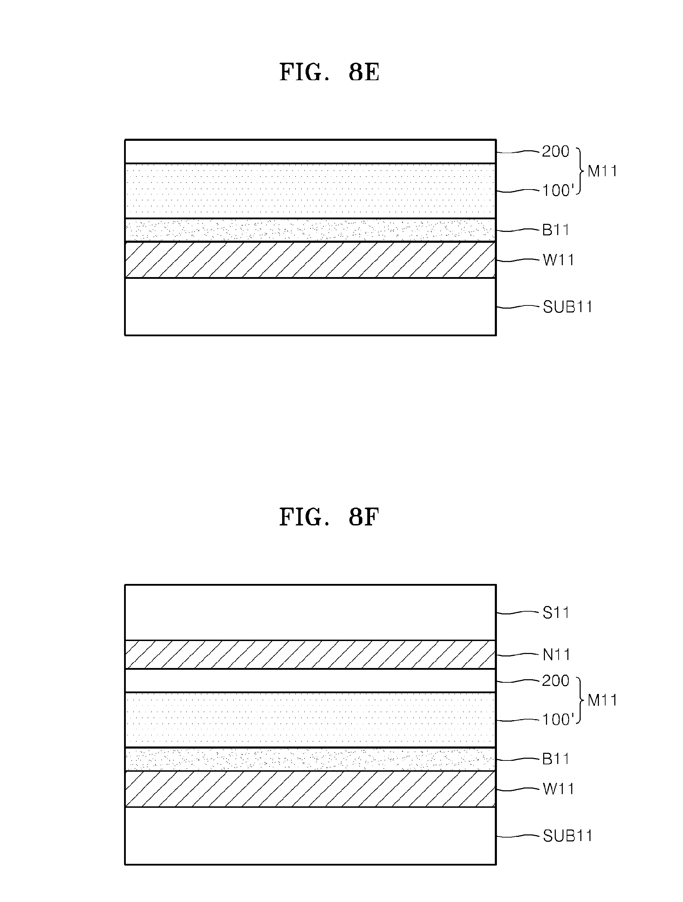

Referring to FIG. 8E, a second material layer 200 may be formed on the first material layer 100'. The second material layer 200 may be formed of a second metal oxide, which is the same group as or a different group from the first metal oxide. For example, the second metal oxide may contain at least one from among Ta oxide, Zr oxide, Y oxide, YSZ, Ti oxide, Hf oxide, Mn oxide, Mg oxide, and a mixture thereof. The second metal oxide may have stoichiometric composition, or a similar composition thereto. For example, when the second metal oxide includes a Ta oxide, the Ta oxide may be a Ta₂O₅ layer, or a layer having a composition similar to Ta₂O₅. The second material layer 200 may correspond to the second material layer 20 of FIG. 1, or the second material layer 22 of FIG. 7. It may be considered that the first material layer 100' and the second material layer 200 constitute a memory layer M11.

The operations as shown in FIGS. 8C through 8E may be successively (or, almost simultaneously) performed in a single operation. For example, when plasma oxidation process is performed on the structure shown in FIG. 8B, metal atoms of the metal layer L11 may diffuse into the first material layer 100, and the second material layer 200 may be formed on the first material layer 100'. As described above, the plasma oxidation process may be performed at a temperature of hundreds of degrees Celsius (e.g., from about 400°C to about 700°C) in an oxygen atmosphere. Due to the temperature condition, simultaneously as metal atoms are diffused by the annealing, the upper portion of the first material layer 100 may be oxidized, and thus, the second material layer 200 may be formed. As described above, in a case of successively (or, almost simultaneously) performing the diffusion of the metal atoms and the formation of the second material layer 200 via a plasma oxidation process, the metal atoms may exist within the second material layer 200. In other words, the second material layer 200 may be doped with the metal atoms. Furthermore, in this case, because the second material layer 200 is a layer formed by oxidizing the upper portion of the first material layer 100', the second material layer 200 may be formed of the same group material (metal oxide) as the material constituting the first material layer 100'. For example, if the first material layer 100' contains TaOₓ, the second material layer 200 may contain Ta₂O₅. However, in a case of separately performing the diffusion of the metal atoms and the formation of the second material layer 200, the second material layer 200 may be formed of a material (metal oxide) that is a different group from the material constituting the first material layer 100'. Furthermore, the second material layer 200 may not contain the metal atoms.

Referring to FIG. 8F, an intermediate electrode N11 may be formed on the memory layer M11. A material constituting the intermediate electrode N11 may correspond to the material constituting the second electrode E2 of FIG. 1, or the first intermediate electrode N10 of FIG. 7. A switching element S11 may be formed on the intermediate electrode N11. The switching element S11 may correspond to the first switching element S10 of FIG. 7.

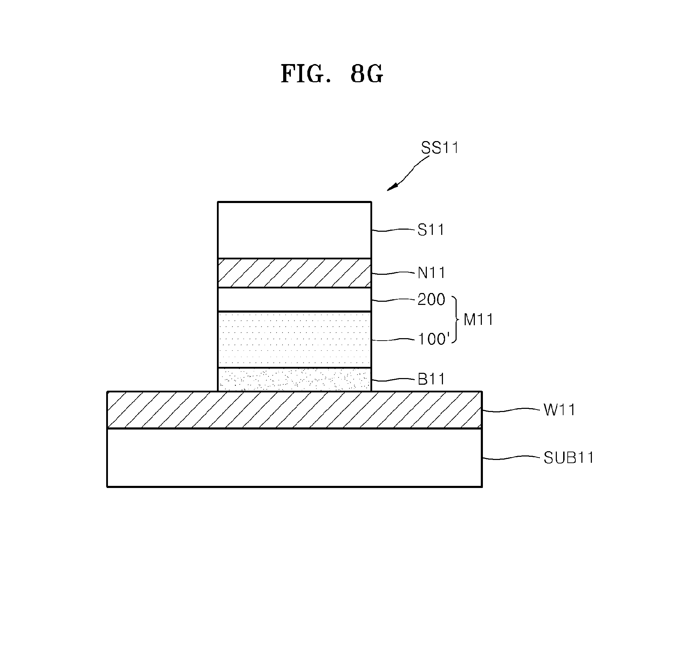

Then, the switching element S11, the intermediate electrode N11, the memory layer M11, and the buffer layer B11 may be patterned. A result thereof is shown in FIG. 8G.

Referring to FIG. 8G, the patterned buffer layer B11, memory layer M11, intermediate electrode N11 and switching element S11 constitute a stacked structure SS11. The stacked structure SS11 may correspond to the first stacked structure SS1 of FIG. 7.

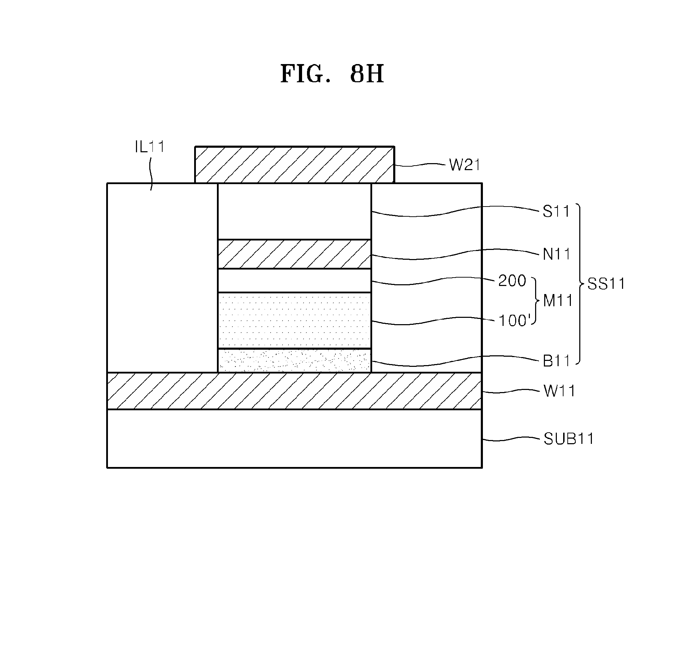

Referring to FIG. 8H, an interlayer insulation layer IL11 may be formed around the stacked structure SS11. The interlayer insulation layer IL11 may have substantially the same thickness as that of the stacked structure SS11. Then, the second wire W21 may be formed on the stacked structure SS11 and the interlayer insulation layer IL11. The second wire W21 may have a linear shape. The second wire W21 may extend in a direction crossing the first wire W11. The second wire W21 may correspond to the second wire W20 of FIG. 7. The shape of the second wire W21 is not limited to a linear shape and may vary. Although not shown, an insulation layer having the same height as the second wire W21 may further be formed around the second wire W21.

The manufacturing method shown in FIGS. 8A through 8H is merely an example, and various modifications may be made thereto. For example, the metal doping method may be replaced with a different method other than the formation and annealing of the metal layer L11. In detail, the first material layer 100 may be doped with a metal via a co-sputtering method. In this case, the first material layer 100 may be doped with the metal while the first material layer 100 is being formed. Various other modifications may be also made thereto.

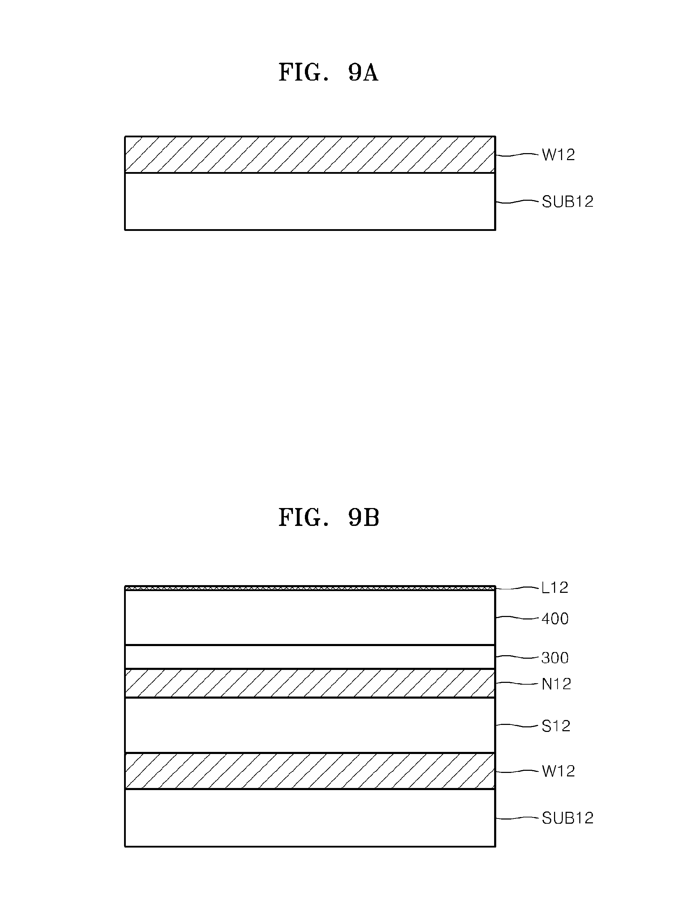

FIGS. 9A through 9G are sectional views showing a method of manufacturing a memory device, according to example embodiments.

Referring to FIG. 9A, a first wire W12 may be formed on a substrate SUB12. The first wire W12 may have a linear shape. Although not shown, an insulation layer having the same height as the first wire W12 may further be formed on the substrate SUB12 around the first wire W12.

Referring to FIG. 9B, a switching element S12, an intermediate electrode N12, a third material layer 300, and a fourth material layer 400 may be formed on the first wire W12 in the order stated. A material constituting the third material layer 300 may correspond to the material constituting the second material layer 20 of FIG. 1 or the third material layer 33 of FIG. 7. The fourth material layer 400 may correspond to the first material layer 10 of FIG. 1 or the fourth material layer 44 of FIG. 7. A desired metal layer L12 may be formed on the fourth material layer 400. The metal layer L12 may be formed of tungsten (W), for example. The thickness of the metal layer L12 may be about several nm.

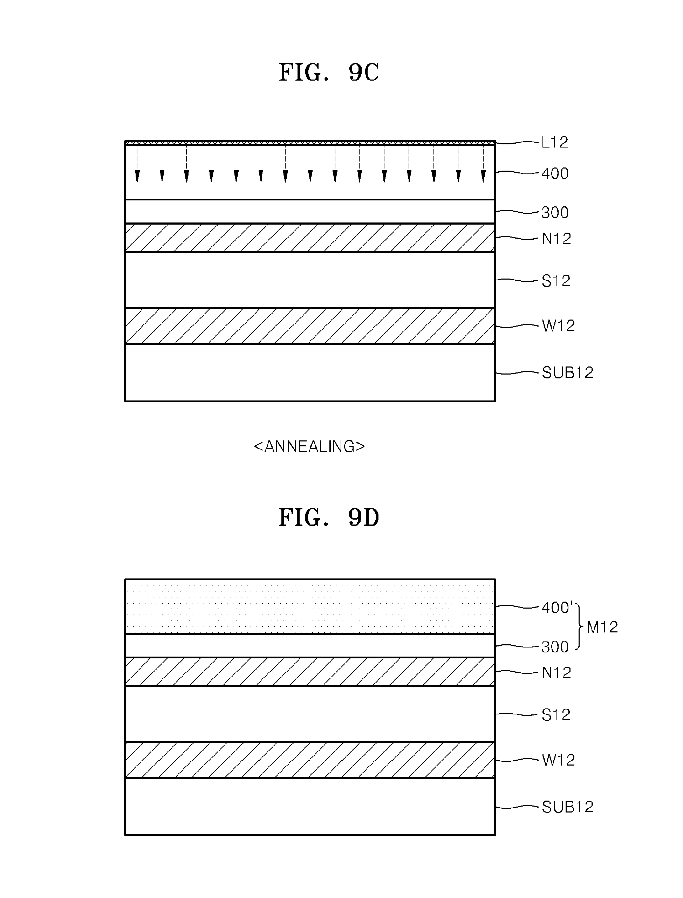

Referring to FIG. 9C, the metal layer L12, the fourth material layer 400 and the third material layer 300 may be annealed. The annealing may be performed at hundreds of degrees Celsius (°C). For example, the annealing may be performed at a temperature from about 300°C to about 800°C. As a result, metal atoms (e.g., W atoms) of the metal layer L12 may diffuse into the fourth material layer 400. As a result, as shown in FIG. 9D, the fourth material layer 400' doped with the metal atoms (e.g., W atoms) may be obtained. Because the thickness of the metal layer L12 that is formed in the operation shown in FIG. 9B is small, no metal layer L12 may remain on the fourth material layer 400' after the annealing. The third material layer 300 and the fourth material layer 400' may constitute a memory layer M12.

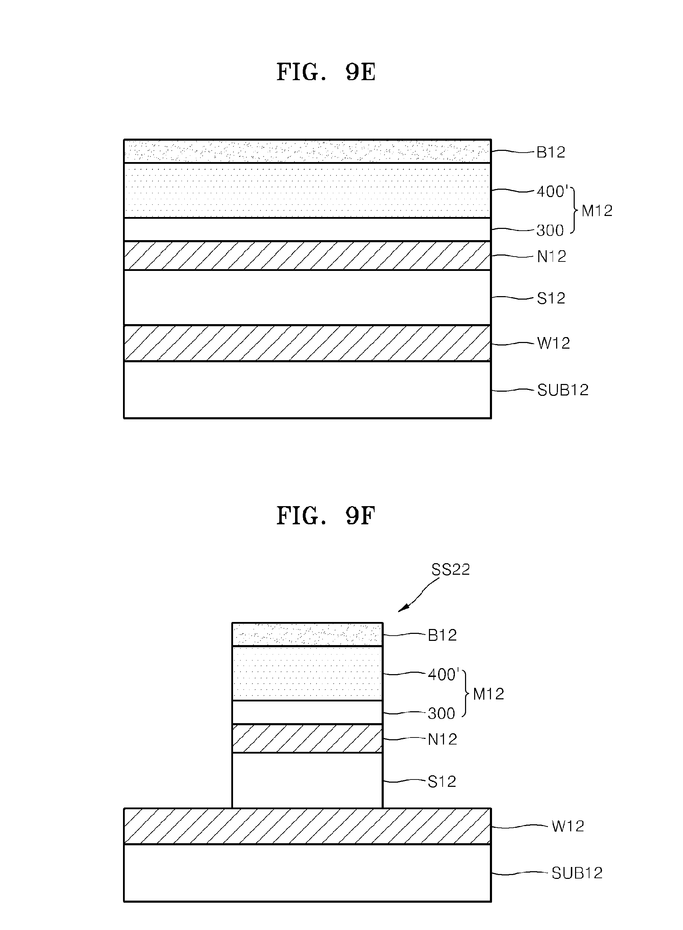

Referring to FIG. 9E, a buffer layer B12 may be formed on the fourth material layer 400'. The buffer layer B12 may correspond to the buffer layer B1 of FIG. 1 or the second buffer layer B20 of FIG. 7.

Then, the buffer layer B12, the memory layer M12, the intermediate layer N12, and the switching element S12 may be patterned. A result thereof is shown in FIG. 9F.

Referring to FIG. 9F, the patterned switching element S12, intermediate layer N12, memory layer M12, and buffer layer B12 constitute a stacked structure SS22. The stacked structure SS22 may correspond to the second stacked structure SS2 of FIG. 7.

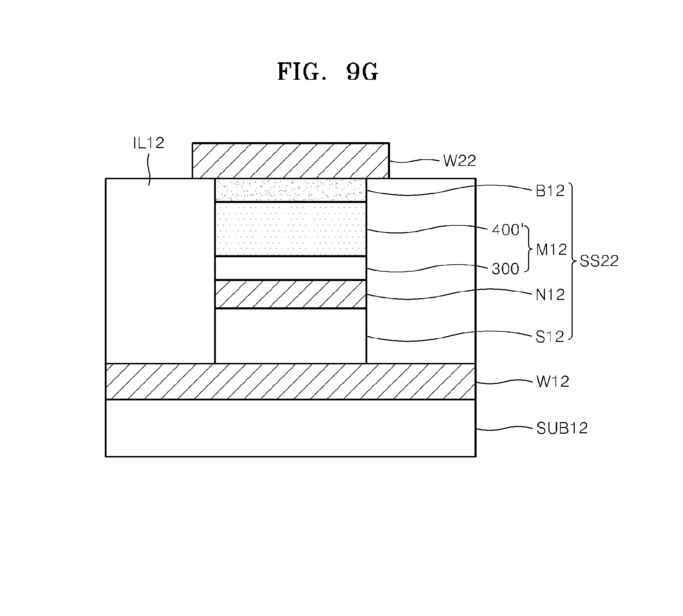

Referring to FIG. 9G, an interlayer insulation layer IL12 may be formed around the stacked structure SS22. The interlayer insulation layer IL12 may have substantially the same thickness as that of the second stacked structure S22. Then, the second wire W22 may be formed on the stacked structure SS22 and the interlayer insulation layer IL12. The second wire W22 may have a linear shape. The second wire W22 may extend in a direction crossing the first wire W12. The shape of the second wire W22 may vary. Although not shown, an insulation layer having the same height as the second wire W22 may further be formed around the second wire W22.

The manufacturing method shown in FIGS. 9A through 9G is merely an example, and various modifications may be made thereto. For example, the thickness and annealing condition of the metal layer L12 may be controlled such that not only the fourth material layer 400 but also at least a portion of the third material layer 300 may be doped with a metal. The metal doping method may be replaced with a different method other than the formation and annealing of the metal layer L12. Various other modifications may be also made thereto.

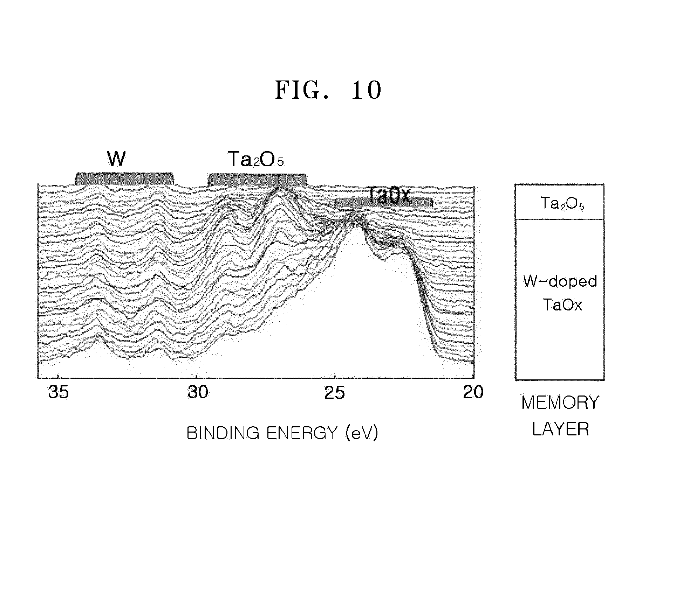

FIG. 10 is a graph showing X-ray photoelectron spectroscopy (XPS) data indicating changes of composition in a depth direction of a memory layer (corresponding to the memory layer M11 of FIG. 8H) manufactured according to example embodiments. Here, the memory layer includes a W-doped TaOₓ layer and a Ta₂O₅ layer. The W-doped TaOₓ layer and the Ta₂O₅ layer correspond to the first material layer 100' and the second material layer 200 of FIG. 8H, respectively.

Referring to FIG. 10, a peak corresponding to Ta₂O₅ appears in the upper portion of the XPS graph, whereas a peak corresponding to TaOₓ appears in the lower portion of the XPS graph. This result may correspond to the structure of the memory layer shown to the right of the graph. Furthermore, a peak corresponding to W appears not only in the region corresponding to TaOₓ but also in the region corresponding to Ta₂O₅. It means that W is contained not only in the TaOₓ layer but also in the Ta₂O₅ layer. Therefore, it is clear that a memory layer including a W-doped TaOₓ layer and a Ta₂O₅ layer may be easily formed.

As described above, according to example embodiments, a non-volatile memory element having a multi-bit memory characteristic and a memory device including the same may be embodied. The non-volatile memory element may be useful for improving integration degree and efficiency of a memory device.

While the present invention has been particularly shown and described with reference to example embodiments thereof, it will be understood by one of ordinary skill in the art that various changes in form and details may be made therein. For example, the memory element as shown in FIG. 1 may also be used as a single-bit memory element instead of a multi-bit memory element. Furthermore, structures of memory elements and memory devices may vary. In detail, at least one additional material layer may be further included in the memory element of FIG. 1, and the memory element of FIG. 1 may be applied not only to a cross-point memory device as shown in FIGS. 6 and 7, but also to any of various other memory devices. In addition, example embodiments may be applied to various other memory devices as well as the resistive memory device. Furthermore, methods of operating and manufacturing memory devices according to example embodiments may also be modified in various ways. Therefore, the scope is defined not by the detailed description but by the appended claims, and all differences within the scope will be construed as being included in the example embodiments.

## Claims

1. A non-volatile memory element, comprising:
a first electrode;
a second electrode spaced apart from the first electrode; and
a memory layer between the first electrode and the second electrode,
wherein the memory layer includes a first material layer and a second material layer,
the memory layer has a resistance change characteristic due to movement of at least one of ionic species and ionic vacancies between the first material layer and the second material layer, and
at least the first material layer of the first and second material layers is doped with a metal.

2. The non-volatile memory element of claim 1, wherein the non-volatile memory element has a multi-bit memory characteristic due to the first material layer.

3. The non-volatile memory element of claim 1 or 2, wherein,
the first material layer is an oxygen-supplying layer, and
the second material layer is an oxygen-exchanging layer.

4. The non-volatile memory element of any preceding claim, wherein the first material layer includes a first metal oxide,
preferably wherein the first metal oxide includes at least one of Ta oxide, Zr oxide, Y oxide, yttria-stabilized zirconia (YSZ), Ti oxide, Hf oxide, Mn oxide, Mg oxide, and a mixture thereof,
further preferably wherein the first metal oxide includes TaOₓ (where 0 < x < 2.5).

5. The non-volatile memory element of any preceding claim, wherein,
the second material layer includes a second metal oxide, and
the second metal oxide is the same group as or a different group than the first metal oxide,
and preferably wherein the second material layer has a higher oxygen concentration than that of the first material layer,
further preferably wherein the second metal oxide includes at least one of Ta oxide, Zr oxide, Y oxide, yttria-stabilized zirconia (YSZ), Ti oxide, Hf oxide, Mn oxide, Mg oxide, and a mixture thereof,
and further preferably wherein the second metal oxide includes Ta₂O₅.

6. The non-volatile memory element of any preceding claim, wherein the metal includes tungsten (W),
and preferably wherein the first material layer includes W-doped TaO₂, and
the second material layer includes Ta₂O₅.

7. The non-volatile memory element of any preceding claim, further comprising a buffer layer between the first electrode and the memory layer,
and preferably wherein the buffer layer includes a material configured for raising a potential barrier between the first electrode and the memory layer,
further preferably wherein the buffer layer includes a material having a greater interatomic bonding energy than that of the memory layer,
and further preferably wherein the buffer layer includes at least one of AlOₓ, SiOₓ, SiNₓ, ZrOₓ, HfOₓ, and a mixture thereof.

8. A memory device, comprising:
a plurality of first wires arranged in parallel to each other;
a plurality of second wires arranged in parallel to each other and crossing the plurality first wires to form a plurality of cross-points; and
a plurality of memory cells, each of the plurality of memory cells being arranged at one of the plurality of cross-points,
wherein each of the plurality of memory cells comprises a non-volatile memory element according to any of claims 1 to 7.

9. The memory device of claim 8, wherein the memory cell further comprises a switching element electrically connected to the non-volatile memory element.

10. The memory device of claim 8 or 9, wherein the plurality of memory cells are a plurality of first memory cells, and the plurality of cross-points are a plurality of first cross-points, and
the memory device further comprising:
a plurality of third wires arranged on the plurality of second wires and crossing the plurality of second wires to form a plurality of second cross-points; and
a plurality of second memory cells, each of the plurality of second memory cells being arranged at one of the plurality of second cross-points,
and preferably wherein each of the plurality of second memory cells has a reverse structure of the plurality of first memory cells or the same structure as the plurality of first memory cells.

11. A method of operating a memory device including a non-volatile memory element, the method comprising:
forming a plurality of ON-states of the non-volatile memory element by controlling a current applied to the non-volatile memory element to adjust the non-volatile memory element to a plurality of current levels; and
corresponding the plurality of ON-states to a plurality of first data bits,
and preferably wherein the current applied to the non-volatile memory element is controlled by a switching element electrically connected to the non-volatile memory element.

12. The method of claim 11, further comprising:
resetting the non-volatile memory element to an OFF-state; and
corresponding the OFF-state of the non-volatile memory element to a second data bit.

13. The method of claim 11 or 12, wherein the plurality of ON-states include at least a first ON-state, a second ON-state and a third ON-state.

14. The method of any of claims 11 to 13, wherein,
the non-volatile memory element includes a memory layer having a first material layer and a second material layer,
the memory layer has a resistance change characteristic due to movement of at least one of ionic species and ionic vacancies between the first and second material layers, and
at least the first material layer of the first and second material layers is doped with a metal,
and preferably wherein the metal includes tungsten (W),
and further preferably wherein the non-volatile memory element has a multi-bit memory characteristic.

15. A method of manufacturing a memory device, the method comprising:
forming a first electrode;
forming a memory layer on the first electrode, wherein the memory layer includes a first material layer and a second material layer and has a resistance change characteristic due to movement of at least one of ionic species and ionic vacancies between the first and second material layers, and at least the first material layer of the first and second material layers is doped with a metal; and
forming a second electrode on the memory layer,
preferably wherein the forming of the memory layer includes: forming a first material layer on the first electrode; forming a metal layer on the first material layer; and diffusing metal atoms of the metal layer into the first material layer,
further preferably wherein the diffusing of the metal atoms into the first material layer includes performing a plasma oxidation process,
and further preferably wherein the second material layer is formed on the first material layer via the plasma oxidation process.
